# EUROPEAN PATENT APPLICATION

(11) **EP 4 411 708 A1**
(43) Date of publication of application: **07.08.2024**
(21) Application number: 24155792.5
(22) Date of filing: 05.02.2024
(51) Int. Cl.: G09G 3/20

(54) **DISPLAY DEVICE**

(30) Priority: 06.02.2023 KR 20230015773
(71) Applicant: Samsung Display Co., Ltd., Yongin-si, Gyeonggi-do 17113 (KR)
(72) Inventor: Lim, Hyungchul, 17113 Yongin-si, Gyeonggi-do, (KR); Noh, Dae-Hyun, 17113 Yongin-si, Gyeonggi-do, (KR); Lee, Dong-Hyun, 17113 Yongin-si, Gyeonggi-do, (KR); Kim, Deukjong, 17113 Yongin-si, Gyeonggi-do (KR); Kim, Hyejin, 17113 Yongin-si, Gyeonggi-do, (KR); Lee, Wanheui, 17113 Yongin-si, Gyeonggi-do, (KR); Yim, Taekyung, 17113 Yongin-si, Gyeonggi-do, (KR)
(74) Representative: Gulde & Partner

(57) **Abstract**

A display device includes: a substrate including a display area, and a non-display area defined around the display area, a driver disposed in the non-display area on the substrate, first crack detection lines disposed in the non-display area on the substrate, where a part of each of the first crack detection lines adjacent to an end of the driver extends in parallel with an edge of the substrate, a second crack detection line disposed in the non-display area on the substrate, electrically connected to the first crack detection lines, and positioned between the first crack detection lines and the driver, and a common voltage line disposed in the non-display area on the substrate. A concave portion overlapping at least a part of the second crack detection line in a plan view is defined at an edge portion of the common voltage line facing the first crack detection lines.

## Description

### BACKGROUND

### 1. Field

Embodiments provide generally to a display device. More particularly, embodiments relate to a display device that provides visual information.

### 2. Description of the Related Art

With the development of information technology, the importance of a display device, which is a connection medium between a user and information, has been highlighted. For example, a display device such as a liquid crystal display device, an organic light emitting display device, a plasma display device, or the like is widely used in various fields.

### SUMMARY

The present invention is set out in the appended set of claims, wherein the drawings and respective description relate to advantageous embodiments thereof. It was an object of the present invention to provide a display device with improved electrostatic discharge, in particular to prevent defects due to electrostatic discharge generated in a crack detection line.

A display device according to embodiments of the present disclosure includes a substrate including a display area, in which a plurality of pixels are disposed, and a non-display area defined around the display area, a driver disposed in the non-display area on the substrate, a plurality of first crack detection lines disposed in the non-display area on the substrate, where at least a part of each of the first crack detection lines adjacent to an end of the driver extends in parallel with an edge of the substrate in a plan view, a second crack detection line disposed in the non-display area on the substrate, and positioned between the first crack detection lines and the driver, where the second crack detection line is electrically connected to the first crack detection lines, and a common voltage line disposed in the non-display area on the substrate, where the common voltage line provides a common voltage to the pixels. In such embodiments, a concave portion overlapping at least a part of the second crack detection line in the plan view is defined at an edge portion of the common voltage line facing the first crack detection lines.

In an embodiment, the display device may further include a first dam disposed in the non-display area on the substrate, and positioned between the first crack detection lines and the driver and a second dam disposed in the non-display area on the substrate, and positioned between the first dam and the first crack detection lines.

In an embodiment, the common voltage line may partially overlap each of the first and second dams in the plan view and the concave portion may partially overlap each of the first and second dams in the plan view.

In an embodiment, the second crack detection line may include a first line part, a first connection part connected to the first line part, a second line part spaced apart from the first line part, and a second connection part connected to the second line part. The first connection part may contact the first line part through a first contact hole and the second connection part may contact the second line part through a second contact hole.

In an embodiment, the first and second contact holes may overlap the first dam in the plan view.

In an embodiment, each of the first and second line parts may partially overlap each of the first and second dams in the plan view.

In an embodiment, parts of the first and second line parts which do not overlap with the first and second dams may be not covered with an organic layer.

In an embodiment, at least a part of each of the first and second line parts does not overlap the first and second dams.

In an embodiment, the second crack detection line may further include a bridge pattern connected between the first and second connection parts. In such an embodiment, each of the first and second connection parts may contact the bridge pattern through a contact hole defined in the driver.

In an embodiment, the display device may further include a first active pattern disposed in the display area on the substrate, a first gate electrode disposed on the first active pattern, a second gate electrode disposed on the first gate electrode, a second active pattern disposed on the second gate electrode, a third gate electrode disposed on the second active pattern, a source electrode and a drain electrode disposed on the third gate electrode, and a connection electrode disposed on the drain electrode.

In an embodiment, each of the first and second line parts may be disposed in a same layer as the source electrode and the drain electrode, the each of the first and second connection parts may be disposed in a same layer as the first gate electrode, and each of the first crack detection lines may be disposed in a same layer as the second gate electrode.

In an embodiment, the first crack detection lines may include a first first crack detection line disposed in a same layer as the first gate electrode, a second first crack detection line disposed in a same layer as the second gate electrode, and a third first crack detection line disposed in a same layer as the third gate electrode.

In an embodiment, the first first crack detection line, the second first crack detection line, and the third first crack detection line may overlap each other in the plan view.

In an embodiment, the common voltage line may include a first layer disposed in a same layer as the source electrode and the drain electrode and a second layer disposed in a same layer as the connection electrode.

In an embodiment, the first crack detection lines may be disposed in a same layer as each other.

A display device according to embodiments of the present disclosure includes a substrate including a display area, in which a plurality of pixels are disposed, and a non-display area defined around the display area, a driver disposed in the non-display area on the substrate, a plurality of first crack detection lines disposed in the non-display area on the substrate, where at least a part of each of the first crack detection lines adjacent to an end of the driver extends in parallel with an edge of the substrate in a plan view, and a second crack detection line disposed in the non-display area on the substrate, and positioned between the first crack detection lines and the driver, where the second crack detection line is electrically connected to the first crack detection lines.

In an embodiment, the display device may further include a first dam disposed in the non-display area on the substrate, and positioned between the first crack detection lines and the driver and a second dam disposed in the non-display area on the substrate, and positioned between the first dam and the first crack detection lines.

In an embodiment, the second crack detection line may include a first line part, a first connection part connected to the first line part, a second line part spaced apart from the first line part, and a second connection part connected to the second line part. The first connection part may contact the first line part through a first contact hole and the second connection part may contact the second line part through a second contact hole.

In an embodiment, the second crack detection line may further include a bridge pattern connected between the first and second connection parts. In an embodiment, each of the first and second connection parts may contact the bridge pattern through a contact hole in the driver.

In an embodiment, the display device may further include a first active pattern disposed in the display area on the substrate, a first gate electrode disposed on the first active pattern, a second gate electrode disposed on the first gate electrode, a second active pattern disposed on the second gate electrode, and a third gate electrode disposed on the second active pattern. In such an embodiment, the first crack detection lines may be disposed in a same layer as the third gate electrode, and each of the first and second connection parts may be disposed in a same layer as the first gate electrode.

In an embodiment, the display device may further include a common voltage line disposed in the non-display area on the substrate, where the common voltage line provides a common voltage to the pixels. In such an embodiment, the common voltage line may overlap the first dam and partially overlap the second dam in the plan view.

In an embodiment, the first and second contact holes may overlap the second dam in the plan view.

In an embodiment, each of the first and second line parts does not overlap the first dam and may overlap the second dam in the plan view.

A display device according to an embodiment of the present disclosure may include a plurality of first crack detection lines disposed in a non-display area, where at least a part of each of the first crack detection lines adjacent to an end of a driver extends in parallel with an edge of the substrate, a second crack detection line disposed in the non-display area, and positioned between the first crack detection lines and the driver, where the second crack detection line is electrically connected to the first crack detection lines, and a common voltage line disposed in the non-display area, where the common voltage line provides a common voltage to the pixels, where a concave portion overlapping at least a part of the second crack detection line in a plan view is defined at an edge portion of the common voltage line facing the first crack detection lines. Accordingly, defects due to electrostatic discharge generated in a crack detection line can be effectively prevented. In addition, the dead space of the display device can be reduced.

A display device according to an embodiment of the present disclosure may include a plurality of first crack detection lines disposed in a non-display area, where at least a part of each of the first crack detection lines adjacent to an end of a driver extends in parallel with an edge of the substrate in a plan view, and a second crack detection line disposed in the non-display area, and positioned between the first crack detection lines and the driver, where the second crack detection line is electrically connected to the first crack detection lines. In such an embodiment, each of the first crack detection lines may be disposed in the same layer as the third gate electrode, and first and second connection parts of the second crack detection line may be disposed in the same layer as a first gate electrode. Accordingly, defects due to electrostatic discharge generated in a crack detection line can be effectively prevented. In addition, the dead space of the display device can be reduced.

### BRIEF DESCRIPTION OF THE DRAWINGS

Illustrative, non-limiting embodiments will be more clearly understood from the following detailed description in conjunction with the accompanying drawings.
FIG. 1 is a plan view illustrating a display device according to an embodiment of the present disclosure.
FIG. 2 is a cross-sectional view illustrating the display device of FIG. 1 in a bent state.
FIG. 3 is an equivalent circuit diagram illustrating an embodiment of each pixel arranged in the display area of FIG. 1.
FIG. 4 is a cross-sectional view taken along line I-I' of FIG. 1.
FIG. 5 is an enlarged plan view of an embodiment corresponding to area A of FIG. 1.
FIG. 6 is a cross-sectional view illustrating an embodiment corresponding to a cross section taken along line II-II' of FIG. 5.
FIG. 7 is a cross-sectional view illustrating an alternative embodiment corresponding to a cross section taken along line II-II' of FIG. 5.
FIG. 8 is a cross-sectional view illustrating another alternative embodiment corresponding to a cross section taken along line II-II' of FIG. 5.
FIG. 9 is a cross-sectional view taken along line III-III' of FIG. 5.
FIG. 10 is a cross-sectional view taken along line IV-IV' of FIG. 5.
FIG. 11 is an enlarged plan view of an alternative embodiment corresponding to area A of FIG. 1.
FIG. 12 is a cross-sectional view taken along line V-V' of FIG. 11.
FIG. 13 is a block diagram illustrating an embodiment of an electronic device including the display device of FIG. 1.
FIG. 14 is a view illustrating an embodiment in which the electronic device of FIG. 13 is implemented as a television.
FIG. 15 is a view illustrating an embodiment in which the electronic device of FIG. 13 is implemented as a smart phone.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, a display device according to embodiments of the present disclosure will be described in detail with reference to the accompanying drawings. The same reference numerals are used for the same components in the drawings, and any repetitive detailed descriptions of the same components will be omitted or simplified.

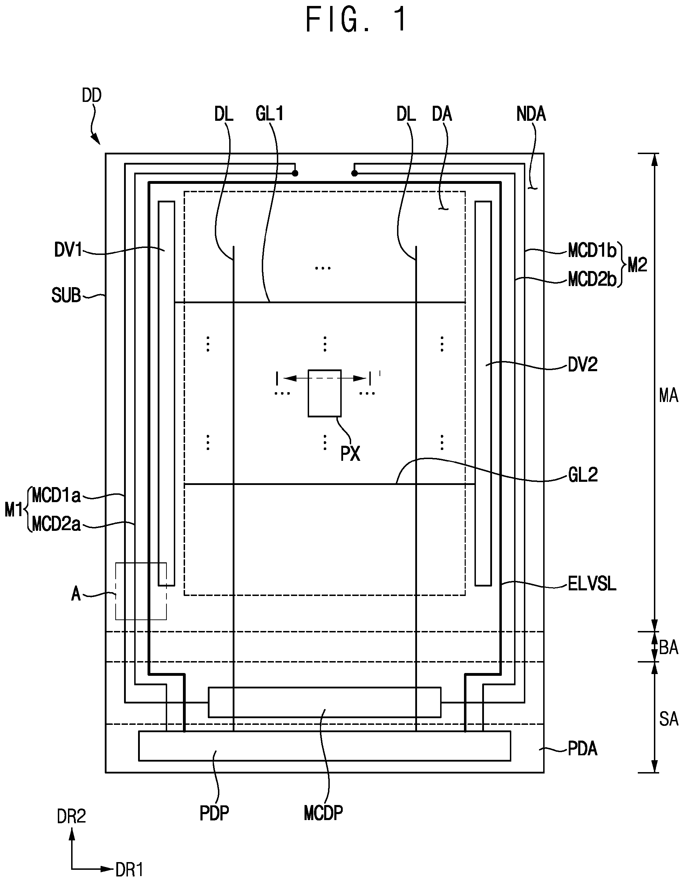

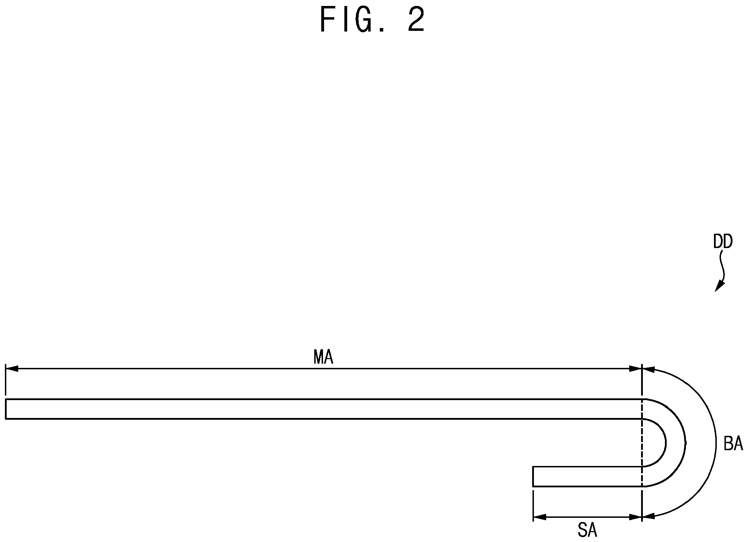

FIG. 1 is a plan view illustrating a display device according to an embodiment of the present disclosure. FIG. 2 is a cross-sectional view illustrating the display device of FIG. 1 in a bent state.

Referring to FIG. 1, a display device DD according to an embodiment may include a substrate SUB, a pad portion PDP, a crack detection circuit portion MCDP, a first crack detection portion M1, a second crack detection portion M1, a common voltage line ELVSL, a data line DL, a first driver DV1, a second driver DV2, a first gate line GL1, and a second gate line GL2.

In an embodiment, the display device DD may have a rectangular planar shape in a plan view or when viewed in a thickness direction thereof. However, embodiments of the present disclosure are not limited thereto, and alternatively, the display device DD may have another shape selected from other various planar shapes.

The substrate SUB may include a main area MA, a bending area BA, and a sub area SA. The main area MA may be flat. The main area MA may include display area DA and a part of the non-display area NDA.

The display area DA may be defined as an area capable of displaying an image by generating light or adjusting transmittance of light provided from an external light source. The non-display area NDA may be defined as an area in which no image is displayed. In addition, the non-display area NDA may be positioned around the display area DA. In an embodiment, for example, the non-display area NDA may entirely surround the display area DA.

The bending area BA may be positioned in at least one side of the main area MA. In an embodiment, as shown in FIG. 2, the bending area BA may be bent based on a bending axis extending in a first direction DR1. In a state where the bending area BA is bent based on the bending axis, the main area MA may overlap the sub area SA. The display device DD may be provided in a shape in which the bending area BA is bent based on the bending axis.

The sub area SA may be parallel to the main area MA. The sub area SA may extend from one side of the bending area BA in a direction opposite to a second direction DR2. Each of the sub area SA and the bending area BA may include a part of the non-display area NDA. In addition, a pad area PDA may be positioned in the sub area SA.

A plurality of pixels PX may be disposed in the display area DA. Each of the plurality of pixels PX may emit light. As each of the plurality of pixels PX emits light, the display area DA may display an image. In an embodiment, for example, the plurality of pixels PX may be arranged in a matrix form along the first direction DR1 and the second direction DR2 crossing the first direction DR1.

One pixel PX may display one predetermined basic color. In other words, one pixel PX may be a minimum (or basic) unit capable of displaying colors independent of other pixels PX. In an embodiment, for example, one pixel PX may display any one color among red, green, and blue.

Lines connected to the plurality of pixels PX may be further disposed in the display area DA. In an embodiment, for example, the lines include a plurality of data lines DL connected to the plurality of pixels PX to provide data voltages, a plurality of gate lines GL1 and GL2 connected to the plurality of pixels PX to provide gate signals, or the like. Each of the data lines DL may extend in the second direction DR2, and each of the gate lines GL1 and GL2 may extend in the first direction DR1.

The first and second drivers DV1 and DV2 for driving the plurality of pixels PX may be disposed in the non-display area NDA. In an embodiment, the first driver DV1 may be disposed in the non-display area NDA adjacent to a left side of the display area DA, and the second driver DV2 may be disposed in the non-display area NDA adjacent to a right side of the display area DA. In an embodiment, for example, each of the first and second drivers DV1 and DV2 may be a gate driver connected to the plurality of gate wires GL1 and GL2 to provide a gate signal to the plurality of pixels PX. Alternatively, either of the first driver DV1 and the second driver DV2 may be omitted.

The pad portion PDP may be disposed in the pad area PDA on the substrate SUB. A driving chip or a circuit board may be electrically connected to the pad part PDP. The driving chip may convert a digital data signal among driving signals into an analog data signal and provide the converted analog data signal to the plurality of pixels PX. In an embodiment, for example, the driving chip may be a data driver. In an embodiment, for example, the circuit board may receive various signals and voltages provided to the plurality of pixels PX.

The common voltage line ELVSL may be disposed in the non-display area NDA on the substrate SUB. In an embodiment, for example, the common voltage line ELVSL may be disposed to surround at least a part of the display area DA. At least a part of the common voltage line ELVSL may be connected to the pad portion PDP.

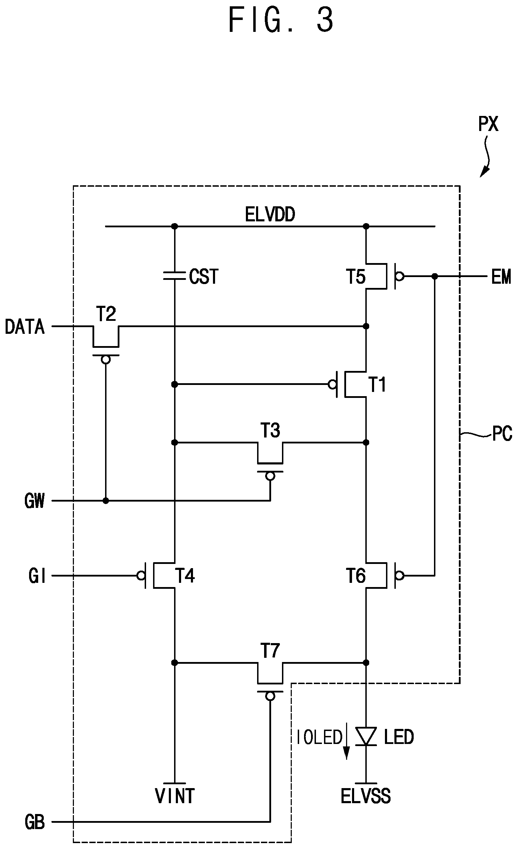

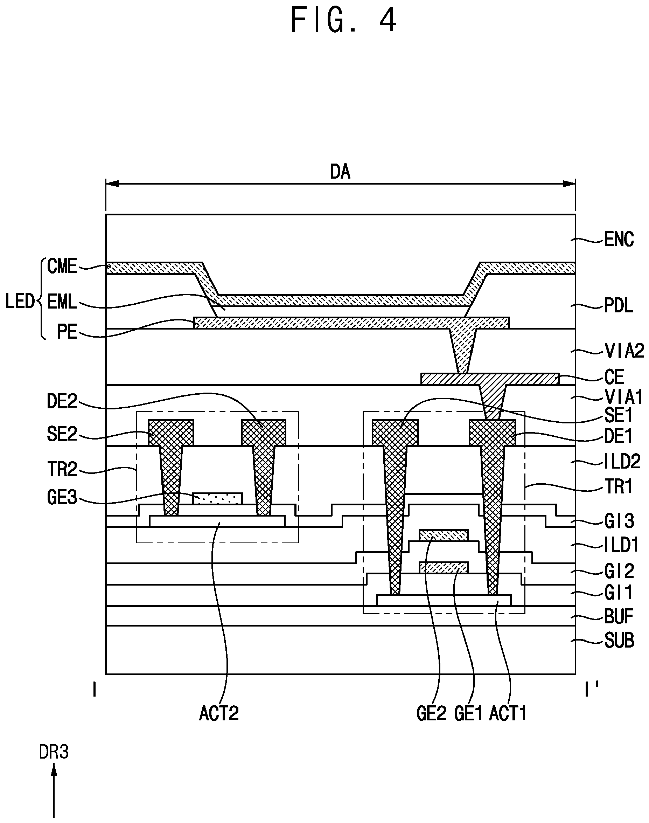

The common voltage line ELVSL may provide a common voltage (e.g., a common voltage ELVSS of FIG. 3) to the plurality of pixels PX. In detail, the common voltage line ELVSL may be electrically connected to a common electrode (e.g., a common electrode CME of FIG. 4) in the non-display area NDA to provide the common voltage to the common electrode.

The first crack detection portion M1 and the second crack detection portion M2 may be disposed in the non-display area NDA on the substrate SUB. The first crack detection portion M1 may be disposed in the non-display area NDA adjacent to the left side and above the display area DA, and the second crack detection portion M2 may be disposed in the non-display area NDA adjacent to the right side and above the display area DA.

The first crack detection portion M1 may include a first crack detection line MCD1a and a second crack detection line MDC2a. The second crack detection portion M2 may include a first crack detection line MCD1b and a second crack detection line MDC2b.

One end (a first end) of the first crack detection line MCD1a and MCD1b may be electrically connected to the crack detection circuit portion MCDP, and the other end (a second end or an opposing end) of the first crack detection line MCD1a and MCD1b may be electrically connected to one end (or a first end) of the second crack detection line MCD2a and MCD2b. In addition, the other end (or an opposing end) of the second crack detection line MCD2a and MCD2b may be electrically connected to the pad portion PDP. A test voltage (e.g., a high voltage) may be applied to the second crack detection line MCD2a and MCD2b through the pad portion PDP.

At least a part of each of the first crack detection lines MCD1a and MCD1b and the second crack detection lines MCD2a and MCD2b may extend parallel to (or along) an edge of the display area DA. The second crack detection lines MCD2a and MCD2b disposed in the non-display area NDA adjacent to the left and right sides of the display area DA may be positioned between the first crack detection lines MCD1a and MCD1b and the driver DV1 and DV2 in a plan view or when viewed in the thickness direction (or a third direction DR3 shown in FIG. 4).

The crack detection circuit portion MCDP may be disposed in the sub area SA on the substrate SUB. In an embodiment, the crack detection circuit portion MCDP may be positioned between the bending area BA and the pad area PDA in the plan view. The crack detection circuit portion MCDP may include a plurality of switching elements. The crack detection circuit portion MCDP may detect defects such as cracks occurring in the non-display area NDA through resistance changes of the first and second crack detection portions M1 and M2. Changes in the resistance of the first and second crack detection portions M1 and M2 may be confirmed by examining the lighting state of the display area DA through the crack detection circuit portion MCDP.

In this specification, a plane may be defined as the first direction DR1 and the second direction DR2 crossing the first direction DR1. In an embodiment, for example, the first direction DR1 may be perpendicular to the second direction DR2.

FIG. 3 is an equivalent circuit diagram illustrating an embodiment of each pixel arranged in the display area of FIG. 1.

Referring to FIG. 3, an embodiment of each pixel PX may include a pixel circuit PC and a light emitting element LED electrically connected to the pixel circuit PC. In an embodiment, for example, as shown in FIG. 3, the pixel circuit PC may include first, second, third, fourth, fifth, sixth, and seventh transistors T1, T2, T3, T4, T5, T6, and T7 and a storage capacitor CST.

The light emitting element LED may output light based on a driving current IOLED. The light emitting element LED may include a first terminal and a second terminal. In an embodiment, for example, the second terminal of the light emitting element LED may receive the common voltage ELVSS. In an embodiment, for example, the first terminal of the light emitting element LED may be an anode terminal, and the second terminal of the light emitting element LED may be a cathode terminal. Alternatively, the first terminal of the light emitting element LED may be a cathode terminal, and the second terminal of the light emitting element LED may be an anode terminal.

The first transistor T1 may include a gate terminal, a first terminal, and a second terminal. In an embodiment, for example, the first terminal of the first transistor T1 may be a source terminal, and the second terminal of the first transistor T1 may be a drain terminal. Alternatively, the first terminal of the first transistor T1 may be a drain terminal, and the second terminal of the first transistor T1 may be a source terminal. This may be equally applied to the second, third, fourth, fifth, sixth, and seventh transistors T2, T3, T4, T5, T6, and T7 to be described below. Therefore, any repetitive detailed descriptions related to first and second terminals of the second, third, fourth, fifth, sixth, and seventh transistors T2, T3, T4, T5, T6, and T7 this will be omitted.

The first transistor T1 may generate driving current IOLED. In an embodiment, the first transistor T1 may be defined (or referred to) as a driving transistor for driving the pixel PX. The first transistor T1 may generate the driving current IOLED based on a voltage difference between the gate terminal and the source terminal. In addition, a gray scale may be expressed in the pixels PX based on the magnitude of the driving current IOLED supplied to the light emitting element LED.

The second transistor T2 may include a gate terminal, a first terminal, and a second terminal. The gate terminal of the second transistor T2 may receive a first scan signal GW. The first terminal of the second transistor T2 may receive a data voltage DATA. The second terminal of the second transistor T2 may be connected to the first terminal of the first transistor T1. The second transistor T2 may be defined as a switching transistor.

The second transistor T2 may supply the data voltage DATA to the first terminal of the first transistor T1 during an activation period of the first scan signal GW, and the second transistor T2 may block the supply of the data signal DATA during an inactive period of the first scan signal GW.

The third transistor T3 may include a gate terminal, a first terminal, and a second terminal. The gate terminal of the third transistor T3 may receive the first scan signal GW. A first terminal of the third transistor T3 may be connected to the first terminal of the first transistor T1. The second terminal of the third transistor T3 may be connected to the gate terminal of the first transistor T1.

The fourth transistor T4 may include a gate terminal, a first terminal, and a second terminal. The gate terminal of the fourth transistor T4 may receive a data initialization signal GI. The first terminal of the fourth transistor T4 may receive an initialization voltage VINT. The second terminal of the fourth transistor may be connected to the second terminal of the third transistor T3.

The fourth transistor T4 may supply the initialization voltage VINT to the second terminal of the third transistor T3 during the activation period of the data initialization signal GI. That is, the fourth transistor T4 may initialize the second terminal of the third transistor T3 to the initialization voltage VINT during an activation period of the data initialization signal GI.

The fifth transistor T5 may include a gate terminal, a first terminal, and a second terminal. The gate terminal of the fifth transistor T5 may receive a light emitting control signal EM. The first terminal of the fifth transistor T5 may receive a driving voltage ELVDD. The second terminal of the fifth transistor T5 may be connected to the first terminal of the first transistor T1.

The fifth transistor T5 may supply the driving voltage ELVDD to the first terminal of the first transistor T1 during an activation period of the light emitting control signal EM, and the fifth transistor T5 may block the supply of the driving voltage ELVDD during an inactive period of the light emitting control signal EM.

The sixth transistor T6 may include a gate terminal, a first terminal, and a second terminal. The gate terminal of the sixth transistor T6 may receive the emission control signal EM. The first terminal of the sixth transistor T6 may be connected to the second terminal of the first transistor T1. The second terminal of the sixth transistor T6 may be connected to the first terminal of the light emitting element LED.

The sixth transistor T6 may supply the driving current IOLED generated by the first transistor T1 to the light emitting element LED during an activation period of the light emission control signal EM, and the sixth transistor T6 may electrically separate the first transistor T1 and the light emitting element LED from each other during the inactive period of the light emitting control signal EM.

The seventh transistor T7 may include a gate terminal, a first terminal, and a second terminal. The gate terminal of the seventh transistor T7 may receive a second scan signal GB. The first terminal of the seventh transistor T7 may receive the initialization voltage VINT. The second terminal of the seventh transistor T7 may be connected to the first terminal of the light emitting element LED.

The seventh transistor T7 may supply the initialization voltage VINT to the first terminal of the light emitting element LED during the activation period of the second scan signal GB. That is, the seventh transistor T7 may initialize the first terminal of the light emitting device LED to the initialization voltage VINT during an activation period of the second scan signal GB.

The storage capacitor CST may include a first terminal and a second terminal. The first terminal of the storage capacitor CST may receive the driving voltage ELVDD. The second terminal of the storage capacitor CST may be connected to the gate terminal of the first transistor T1.

Although an embodiment having the pixel circuit PC including seven transistors and one storage capacitor is described above with reference to FIG. 3, embodiments of the present disclosure are not limited thereto. In an embodiment, for example, the pixel circuit PC may have a configuration including at least one transistor and at least one storage capacitor.

FIG. 4 is a cross-sectional view taken along line I-I' of FIG. 1. Particularly, FIG. 4 is a cross-sectional view illustrating a part of the display area DA of FIG. 1.

Referring to FIG. 4, the display device DD according to an embodiment may include the substrate SUB, a buffer layer BUF, a first transistor TR1, a second transistor TR2, first, second, and third gates. insulating layers GI1, GI2, and GI3, first and second interlayer insulating layers ILD1 and ILD2, a first via insulating layer VIA1, a second via insulating layer VIA2, a connection electrode CE, a pixel defining layer PDL, the light emitting element LED, and an encapsulation layer ENC.

In such an embodiment, the first transistor TR1 may include a first active pattern ACT1, a first gate electrode GE1, a second gate electrode GE2, a first source electrode SE1, and a first drain electrode DE1. The second transistor TR2 may include a second active pattern ACT2, a third gate electrode GE3, a second source electrode SE2, and a second drain electrode DE2. In addition, the light emitting element LED may include a pixel electrode PE, a light emitting layer EML, and a common electrode CME.

The substrate SUB may include a transparent material or an opaque material. The substrate SUB may include or be made of a transparent resin substrate. Examples of the transparent resin substrate may include polyimide substrate or the like. In this case, the polyimide substrate may include a first organic layer, a first barrier layer, a second organic layer, or the like. Alternatively, the substrate SUB may include a quartz substrate, a synthetic quartz substrate, a calcium fluoride substrate, an F-doped quartz substrate, a soda-lime glass substrate, a non-alkali glass substrate, or the like. These may be used alone or in combination with each other.

The buffer layer BUF may be disposed on the substrate SUB. The buffer layer BUF may prevent diffusion of metal atoms or impurities from the substrate SUB into the first and second transistors TR1 and TR2. In addition, the buffer layer BUF may improve flatness of the surface of the substrate SUB when the surface of the substrate SUB is not uniform. In an embodiment, for example, the buffer layer BUF may include an inorganic material such as silicon oxide, silicon nitride, silicon oxynitride, or the like. These may be used alone or in combination with each other.

The first active pattern ACT1 may be disposed on the buffer layer BUF. In an embodiment, the first active pattern ACT1 may include an inorganic semiconductor such as amorphous silicon or polycrystalline silicon. In an embodiment, for example, the first active pattern ACT1 may have a first source region, a first drain region, and a first channel region positioned between the first source region and the first drain region.

The first gate insulating layer GI1 may be disposed on the buffer layer BUF. The first gate insulating layer GI1 may cover the first active pattern ACT1 and may be disposed along the profile of the first active pattern ACT1 to have a uniform thickness. Alternatively, the first gate insulating layer GI1 may sufficiently cover the first active pattern ACT1 and may have a substantially flat upper surface without creating a step around the first active pattern ACT1. In an embodiment, for example, the first gate insulating layer GI1 includes an inorganic material such as silicon oxide (SiOₓ), silicon nitride (SiNₓ), silicon carbide (SiCₓ), silicon oxynitride (SiOₓN_{y}), silicon oxycarbide (SiOₓC_{y}), or the like. These may be used alone or in combination with each other.

The first gate electrode GE1 may be disposed on the first gate insulating layer GI1. The first gate electrode GE1 may overlap the first channel region of the first active pattern ACT1. The first gate electrode GE1 may include a metal, an alloy, a metal nitride, a conductive metal oxide, a transparent conductive material, or the like. Examples of the metal may include silver (Ag), molybdenum (Mo), aluminum (Al), tungsten (W), copper (Cu), nickel (Ni), chromium (Cr), titanium (Ti), tantalum (Ta), platinum (Pt), scandium (Sc), or the like. Examples of the conductive metal oxide may include indium tin oxide, indium zinc oxide, or the like. In addition, examples of the metal nitride may include aluminum nitride (AlNₓ), tungsten nitride (WNₓ), chromium nitride (CrNₓ), or the like. Each of these may be used alone or in combination with each other.

The second gate insulating layer GI2 may be disposed on the first gate insulating layer GI1. The second gate insulating layer GI2 may cover the first gate electrode GE1 and may be disposed along the profile of the first gate electrode GE1 to have uniform thickness. Alternatively, the first gate insulating layer GI1 may sufficiently cover the first gate electrode GE1 and may have a substantially flat upper surface without creating a step around the first gate electrode GE1. In an embodiment, for example, the second gate insulating layer GI2 may include an inorganic material such as silicon oxide, silicon nitride, silicon oxynitride, or the like. These may be used alone or in combination with each other.

The second gate electrode GE2 may be disposed on the second gate insulating layer GI2. The second gate electrode GE2 may overlap the first gate electrode GE1. In an embodiment, for example, the second gate electrode GE2 may include a metal, an alloy, a metal nitride, a conductive metal oxide, a transparent conductive material, or the like. These may be used alone or in combination with each other.

The first interlayer insulating layer ILD1 may be disposed on the second gate insulating layer GI2. The first interlayer insulating layer ILD1 may cover the second gate electrode GE2 and may be disposed along the profile of the second gate electrode GE2 to have a uniform thickness. Alternatively, the first interlayer insulating layer ILD1 may sufficiently cover the second gate electrode GE2 and may have a substantially flat upper surface without creating a step around the second gate electrode GE2. In an embodiment, for example, the first interlayer insulating layer ILD1 may include an inorganic material such as silicon oxide, silicon nitride, silicon oxynitride, or the like. These may be used alone or in combination with each other.

The second active pattern ACT2 may be disposed on the first interlayer insulating layer ILD1. In an embodiment, the second active pattern ACT2 may include a metal oxide semiconductor. In an embodiment, for example, the second active pattern ACT2 may have a second source region, a second drain region, and a second channel region positioned between the second source region and the second drain region.

The metal oxide semiconductor may include a two-component compound (ABₓ), a ternary compound (ABₓC_{y}), a four-component compound (ABₓC_{y}D_{z}), or the like containing indium (In), zinc (Zn), gallium (Ga), tin (Sn), titanium (Ti), aluminum (Al), hafnium (Hf), zirconium (Zr), magnesium (Mg), or the like. In an embodiment, for example, the metal oxide semiconductor may include zinc oxide (ZnOₓ), gallium oxide (GaOₓ), tin oxide (SnOₓ), indium oxide (InOₓ), indium gallium oxide (IGO), indium zinc oxide (IZO), indium tin oxide. (ITO), indium zinc tin oxide (IZTO), indium gallium zinc oxide (IGZO), or the like. These may be used alone or in combination with each other.

The third gate insulating layer GI3 may be disposed on the first interlayer insulating layer ILD1. The third gate insulating layer GI3 may cover the second active pattern ACT2 and may be disposed along the profile of the second active pattern ACT2 to have a uniform thickness. Alternatively, the third gate insulating layer GI3 may sufficiently cover the second active pattern ACT2 and may have a substantially flat upper surface without creating a step around the second active pattern ACT2. In an embodiment, for example, the third gate insulating layer GI3 may include an inorganic material such as silicon oxide, silicon nitride, silicon oxynitride, or the like. These may be used alone or in combination with each other.

The third gate electrode GE3 may be disposed on the third gate insulating layer GI3. The third gate electrode GE3 may overlap the second channel region of the second active pattern ACT2. In an embodiment, for example, the third gate electrode GE3 may include a metal, an alloy, a metal nitride, a conductive metal oxide, a transparent conductive material, or the like. These may be used alone or in combination with each other.

The second interlayer insulating layer ILD2 may be disposed on the third gate insulating layer GI3. The second interlayer insulating layer ILD2 may sufficiently cover the third gate electrode GE3 and may have a substantially flat upper surface without creating a step around the third gate electrode GE3. Alternatively, the second interlayer insulating layer ILD2 may cover the third gate electrode GE3 and may be disposed along the profile of the third gate electrode GE3 to have a uniform thickness. In an embodiment, for example, the second interlayer insulating layer ILD2 may include an inorganic material such as silicon oxide, silicon nitride, silicon oxynitride, or the like. These may be used alone or in combination with each other.

The first source electrode SE1 and the first drain electrode DE1 may be disposed on the second interlayer insulating layer ILD2. The first source electrode SE1 may be connected to the first source region of the first active pattern ACT1 through a contact hole defined or formed through insulating layers (e.g., the first, second, and third gate insulating layers GI1, GI2, and GI3 and the first and second interlayer insulating layers ILD1 and ILD2). The first drain electrode DE1 may be connected to the first drain region of the first active pattern ACT1 through a contact hole defined or formed through insulating layers (e.g., the first, second, and third gate insulating layers GI1, GI2, and GI3 and the first and second interlayer insulating layers ILD1 and ILD2). In an embodiment, for example, the first source electrode SE1 and the first drain electrode DE1 may include a metal, an alloy, a metal nitride, a conductive metal oxide, a transparent conductive material, or the like. These may be used alone or in combination with each other.

The second source electrode SE2 and the second drain electrode DE2 may be disposed on the second interlayer insulating layer ILD2. The second source electrode SE2 may be connected to the second source region of the second active pattern ACT2 through a contact hole defined or formed through the third gate insulating layer GI3 and the second interlayer insulating layer ILD2. The second drain electrode DE2 may be connected to the second drain region of the second active pattern ACT2 through a contact hole defined or formed through the third gate insulating layer GI3 and the second interlayer insulating layer ILD2. The second source electrode SE2 and the second drain electrode DE2 may include a same material as the first source electrode SE1 and the first drain electrode DE1 and may be disposed in a same layer as the first source electrode SE1 and the first drain electrode DE1.

Accordingly, the first transistor TR1 includes the first active pattern ACT1, the first gate electrode GE1, the second gate electrode GE2, the first source electrode SE1, and the first drain electrode DE1 may be formed, and the second transistor TR2 including the second active pattern ACT2, the third gate electrode GE3, the second source electrode SE2 and the second drain electrode DE2 may be formed.

The first via insulating layer VIA1 may be disposed on the second interlayer insulation layer ILD2. The first via insulating layer VIA1 may sufficiently cover the first source electrode SE1, the first drain electrode DE1, the second source electrode SE2, and the second drain electrode DE2. The first via insulating layer VIA1 may include an organic material. In an embodiment, for example, the first via insulating layer VIA1 may include an organic material such as polyimide resin, polyamide resin, siloxane resin, epoxy resin, or the like. These may be used alone or in combination with each other.

The connection electrode CE may be disposed on the first via insulating layer VIA1. The connection electrode CE may be connected to the first drain electrode DE1 through a contact hole defined or formed through the first via insulating layer VIA1. Accordingly, the connection electrode CE may electrically connect the first transistor TR1 and the light emitting element LED. In an embodiment, for example, the connection electrode CE may include a metal, an alloy, a metal nitride, a conductive metal oxide, a transparent conductive material, or the like. These may be used alone or in combination with each other.

The second via insulating layer VIA2 may be disposed on the first via insulation layer VIA1. The second via insulating layer VIA2 may sufficiently cover the connection electrode CE. The second via insulating layer VIA2 may have a substantially flat upper surface. The second via insulating layer VIA2 may include an organic material. In an embodiment, for example, the second via insulation layer VIA2 may include an organic material such as polyimide resin, polyamide resin, siloxane resin, epoxy resin, or the like. These may be used alone or in combination with each other.

The pixel electrode PE may be disposed on the second via insulating layer VIA2. The pixel electrode PE may be connected to the connection electrode CE through a contact hole defined or formed through the second via insulating layer VIA2. In an embodiment, for example, the pixel electrode PE may include a metal, an alloy, a metal nitride, a conductive metal oxide, a transparent conductive material, or the like. These may be used alone or in combination with each other. In an embodiment, for example, the pixel electrode PE may act as an anode.

The pixel defining layer PDL may be disposed on the second via insulating layer VIA2. The pixel defining layer PDL may cover an edge of the pixel electrode PE. In an embodiment, for example, the pixel defining layer PDL may include an inorganic material and/or an organic material. In an embodiment, the pixel defining layer PDL may include an organic material such as an epoxy resin, a siloxane resin, or the like. These may be used alone or in combination with each other. In an alternative embodiment, the pixel defining layer PDL may include an inorganic material and/or an organic material including a light blocking material containing black pigment, black dye, or the like.

The emitting layer EML may be disposed on the pixel electrode PE. The light emitting layer EML may include an organic material that emits light of a predetermined color. In an embodiment, for example, the light emitting layer EML may include an organic material that emits at least one of red light, green light, and blue light.

The common electrode CME may be disposed on the pixel defining layer PDL and the light emitting layer EML. In an embodiment, for example, the common electrode CME may include a metal, an alloy, a metal nitride, a conductive metal oxide, a transparent conductive material, or the like. These may be used alone or in combination with each other. In an embodiment, for example, the common electrode CME may operate as a cathode.

Accordingly, the light emitting element LED including the pixel electrode PE, the light emitting layer EML, and the common electrode CME may be formed.

The encapsulation layer ENC may be disposed on the common electrode CME. The encapsulation layer ENC may prevent impurities, moisture, air, and the like from permeating the light emitting element LED from the outside. The encapsulation layer ENC may include at least one inorganic layer and at least one organic layer. In an embodiment, for example, the inorganic layer may include silicon oxide, silicon nitride, silicon oxynitride, or the like. These may be used alone or in combination with each other. The organic layer may include a polymer cured material such as polyacrylate or the like.

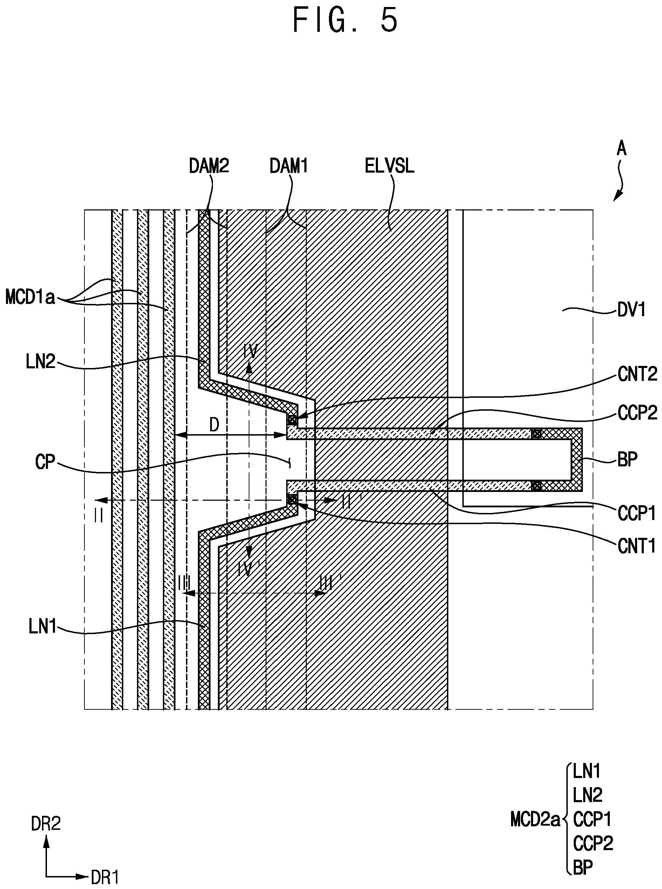

FIG. 5 is an enlarged plan view of an embodiment corresponding to area A of FIG. 1. Particularly, FIG. 5 is an enlarged plan view of a part of the non-display area NDA adjacent to the left side of the display area DA of FIG. 1. A part of the non-display area NDA adj acent to the right side of the display area DA of FIG. 1 may have a substantially structure as that shown in FIG. 5.

Hereinafter, any repetitive detailed descriptions of the same or like elements as those of the display device DD described above with reference to FIG. 1 will be omitted or simplified.

Referring to FIGS. 1 and 5, an embodiment of the display device DD may include the first crack detection portion M1, the second crack detection portion M2, the common voltage line ELVSL, the first dam DAM1, the second dam DAM2, and the first driver DV1 disposed in the non-display area NDA on the substrate SUB.

The first crack detection portion M1 may include the first crack detection lines MCD1a and second crack detection lines MCD2a. The second crack detection portion M2 may include the first crack detection lines MCD1b and second crack detection lines MCD2b.

The number of first crack detection lines MCD1a may be plural, that is, the first crack detection line MCD1a may be provided in plural. In an embodiment, for example, the number of first crack detection lines MCD1a may be three, that is, three first crack detection lines MCD1a may be provided. However, embodiments of the present disclosure are not limited thereto, and various numbers of first crack detection lines MCD1a may be provided.

A part of the first crack detection line MCD1a may extend along the second direction DR2. In an embodiment, at least a part of the first crack detection line MCD1a adjacent to an end of the first driver DV1 may extend parallel to an edge of the substrate SUB. That is, at least the part of the first crack detection line MCD1a adjacent to the end of the first driver DV1 may not be bent.

Each of the first and second dams DAM1 and DAM2 may surround at least a part of the display area DA. The first and second dams DAM1 and DAM2 may block an organic material from flowing toward the edge of the substrate SUB when an organic layer of the encapsulation layer (e.g., the encapsulation layer ENC of FIG. 4) is formed.

The first dam DMA1 may be positioned between the first crack detection line MCD1a and the first driver DV1 in the plan view. The second dam DMA2 may be positioned between the first crack detection line MCD1a and the first dam DAM1 in the plan view.

In an embodiment, a concave (or recessed) portion CP overlapping at least a part of the second crack detection line MCD2a in the plan view may be defined at an edge portion of the common voltage line ELVSL facing the first crack detection line MCD1a.

In an embodiment, the common voltage line ELVSL may partially overlap each of the first and second dams DAM1 and DAM2 in the plan view. In addition, the concave portion CP may partially overlap each of the first and second dams DAM1 and DAM2 in the plan view.

The second crack detection line MCD2a may include a first line part LN1, a second line part LN2, a first connection part CCP1, a second connection part CCP2, and a bridge pattern BP. The first line part LN1 may contact the first connection part CCP1 through a first contact hole CNT1, and the second line part LN2 may contact the second connection part CCP2 through a second contact hole CNT2. In addition, the first and second connection parts CC1 and CCP2 may be connected to each other through the bridge pattern BP. In such an embodiment, each of the first and second connection parts CCP1 and CCP2 may contact the bridge pattern BP through a contact hole CNT1, CNT2 defined in the first driver DV1.

In an embodiment, the first and second contact holes CNT1 and CNT2 may overlap the first dam DAM1 in the plan view. That is, the first and second contact holes CNT1 and CNT2 may overlap the concave portion CP in the plan view.

In an embodiment, the first and second line parts LN1 and LN2 may partially overlap the first and second dams DAM1 and DAM2, respectively. That is, one side of each of the first and second line parts LN1 and LN2 may be bent in a direction from the second dam DAM2 toward the first dam DAM1 inside the concave part CP.

In an embodiment, at least a part of each of the first and second line parts LN1 and LN2 may not overlap the first and second dams DAM1 and DAM2 in the plan view. That is, a part of each of the first and second line parts LN1 and LN2 does not overlap the first and second dams DAM1 and DAM2, and another part of each of the first and second line parts LN1 and LN2 may overlap the first and second dams DAM1 and DAM2.

The first and second connection parts CCP1 and CCP2 may be spaced apart from the first crack detection line MCD1a by a predetermined distance in the plan view. In an embodiment, for example, a shortest distance D between the first connection part CCP1 (or the second connection part CCP2) and the first crack detection line MCD1a may be about 50 micrometers. Accordingly, defects due to electrostatic discharge (ESD) occurring in the first and second connection parts CCP1 and CCP2 may be effectively prevented.

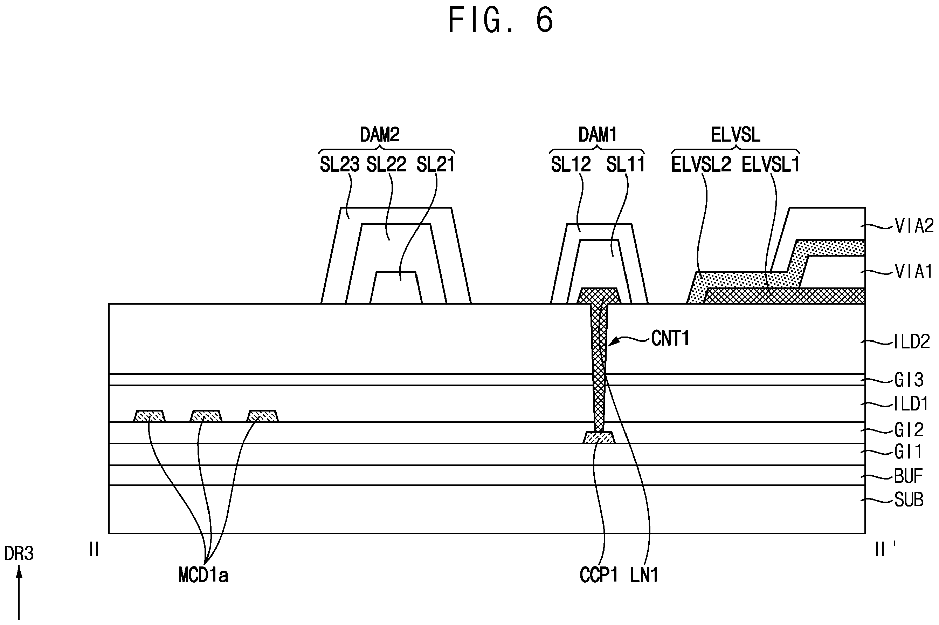

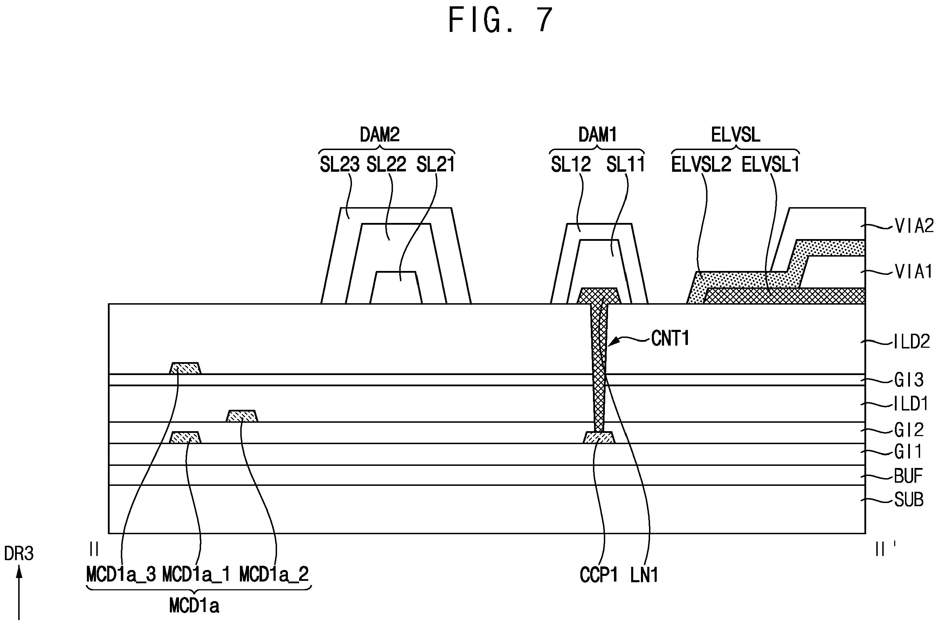

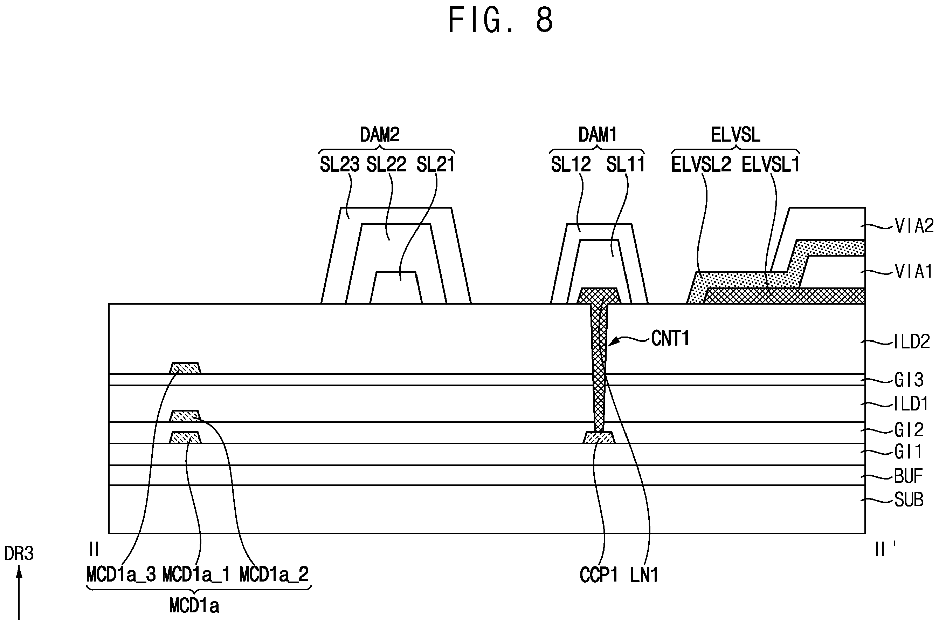

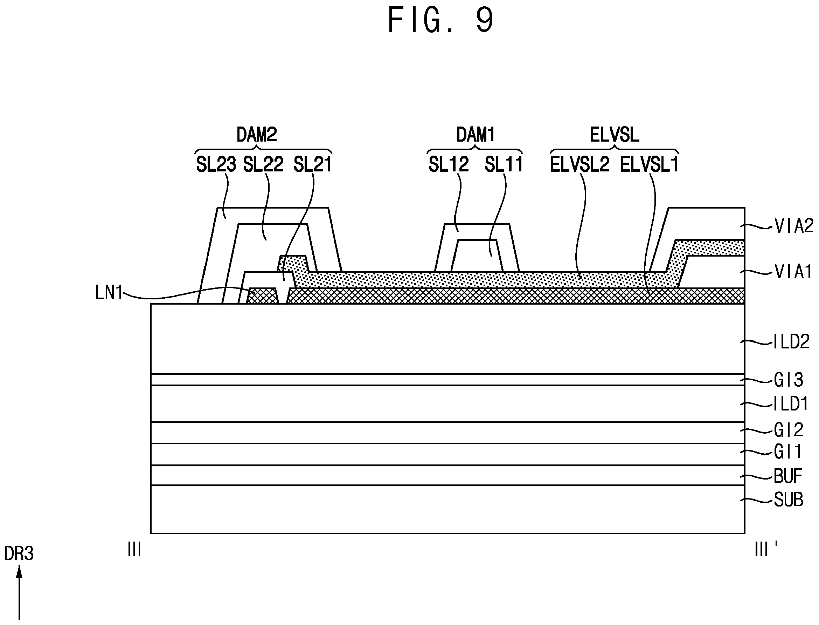

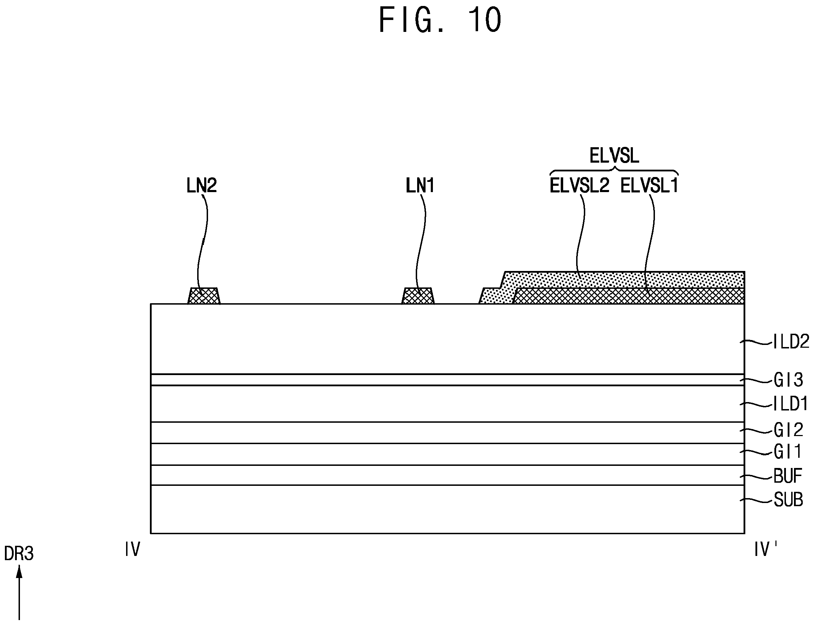

FIG. 6 is a cross-sectional view illustrating an embodiment corresponding to a cross section taken along line II-II' of FIG. 5. FIG. 7 is a cross-sectional view illustrating an alternative embodiment corresponding to a cross section taken along line II-II' of FIG. 5. FIG. 8 is a cross-sectional view illustrating another alternative embodiment corresponding to a cross section taken along line II-II' of FIG. 5. FIG. 9 is a cross-sectional view taken along line III-III' of FIG. 5. FIG. 10 is a cross-sectional view taken along line IV-IV' of FIG. 5.

Hereinafter, any repetitive detailed descriptions of the same or like elements as those of the display device DD described above with reference to FIGS. 1 and 4 will be omitted or simplified.

Referring to FIG. 6, in an embodiment where the first crack detection line MCD1a is provided in plural, the first crack detection lines MCD1a may be disposed in a same layer as each other. In an embodiment, the first crack detection line MCD1a may be disposed in a same layer as a second gate electrode (e.g., the second gate electrode GE2 of FIG. 4). That is, the first crack detection line MCD1a may be formed using a same material as the second gate electrode through a same process on the second gate insulating layer GI2.

Referring to FIGS. 7 and 8, in an alternative embodiment, the first crack detection lines MCD1a may be disposed in different layers from each other. In an embodiment, for example, the first crack detection lines MCD1a may include a first first crack detection line MCD1a_1, a second first crack detection line MCD1a_2, and a third first crack detection line MCD1a_3. In an embodiment, the first first crack detection line MCD1a_1 may be disposed in a same layer as a first gate electrode (e.g., the first gate electrode GE1 of FIG. 4), the second first crack detection line MCD1a_2 may be disposed in a same layer as a second gate electrode (e.g., the second gate electrode GE2 of FIG. 4), and the third first crack detection line MCD1a_3 may be disposed in a same layer as a third gate electrode (e.g., the third gate electrode GE3 of FIG. 4). That is, the first first crack detection line MCD1a_1 may be formed using a same material as the first gate electrode through a same process on the third gate insulating layer GI3, the second first crack detection line MCD1a_2 may be formed using a same material as the second gate electrode through a same process on the second gate insulating layer GI2, and the third first crack detection line MCD1a_3 may be formed using a same material as the third gate electrode through a same process on the first gate insulating layer GI1.

In an embodiment, as shown in FIG. 7, the first first crack detection line MCD1a_1 may overlap the third first crack detection line MCD1a_3 in the plan view, the second first crack detection line MCD1a_2 may be spaced apart from the first first crack detection line MCD1a_1 and the third first crack detection line MCD1a_3 in the plan view.

In an alternative embodiment, as shown in FIG. 8, the first first crack detection line MCD1a_1, the second first crack detection line MCD1a_2, and the third first crack detection line MCD1a_3 may overlap each other in the plan view. However, embodiments of the present disclosure are not limited thereto.

The first and second connection parts CCP1 and CCP2 may be disposed on the first gate insulating layer GI1. In an embodiment, the first and second connection parts CCP1 and CCP2 may be disposed in a same layer as the first gate electrode. That is, the first and second connection parts CCP1 and CCP2 may be formed through a same process using a same material as the first gate electrode on the first gate insulating layer GI1.

The first and second line parts LN1 and LN2 may be disposed on the second interlayer insulating layer ILD2. In an embodiment, the first and second line parts LN1 and LN2 may be disposed in a same layer as a source electrode (e.g., the first and second source electrodes SE1 and SE2 of FIG. 4) and a drain electrode (e.g., the first and second drain electrodes DE1 and DE2 of FIG. 4). That is, the first and second line parts LN1 and LN2 may be formed using a same material as the source electrode and the drain electrode through a same process on the second interlayer insulating layer ILD2.

In an embodiment, referring to FIGS. 9 and 10, the first dam DAM1 and the second dam DAM2 may be disposed on the second interlayer insulating layer ILD2. In an embodiment, for example, the first dam DAM1 may include a first sub-layer SL11 and a second sub-layer SL12 disposed on the first sub-layer SL11. The second dam DAM2 may include a first sub-layer SL21, a second sub-layer SL22 disposed on the first sub-layer SL21, and a third sub-layer SL23 disposed on the second sub-layer SL22.

The first sub-layer SL11 of the first dam DAM1 may include a same material as the second via insulating layer VIA2, and the second sub-layer SL12 of the first dam DAM1 may include a same material as a pixel defining layer (e.g., the pixel defining layer PDL of FIG. 4). In addition, the first sub-layer SL21 of the second dam DAM2 may include the same material as the first via insulating layer VIA1, the second sub-layer SL22 of the second dam DAM2 may include a same material as the second via insulation layer VIA2, and the third sub-layer SL23 of the second dam DAM2 may include a same material as the pixel defining layer.

The first dam DAM1 may cover at least a part of each of the first and second line parts LN1 and LN2. In addition, the second dam DAM2 may cover at least a part of each of the first and second line parts LN1 and LN2.

In an embodiment, parts of the first and second line parts LN1 and LN2 that do not overlap the first and second dams DAM1 and DAM2 may not be covered with an organic layer (see FIG. 10). In such an embodiment, the first dam DAM1 and the second dam DAM2 may not be connected to each other. Accordingly, a moisture permeation path may not be formed through the first and second dams DAM1 and DAM2.

The common voltage line ELVSL may be disposed on the second interlayer insulating layer ILD2. The common voltage line ELVSL may have a multilayer structure. In an embodiment, for example, the common voltage line ELVSL may include a first layer ELVSL1 and a second layer ELVSL2 disposed on the first layer ELVSL1. In an embodiment, the first layer ELVSL1 may be disposed in a same layer as the source electrode SE1, SE2 and the drain electrode DE1, DE2, and the second layer ELVSL2 may be disposed in a same layer as a connection electrode (e.g., the connection electrode CE of FIG. 4). That is, the first layer ELVSL1 may be formed using a same material as the source electrode and the drain electrode through a same process, and the second layer ELVSL2 may be formed using a same material as the connection electrode through a same process.

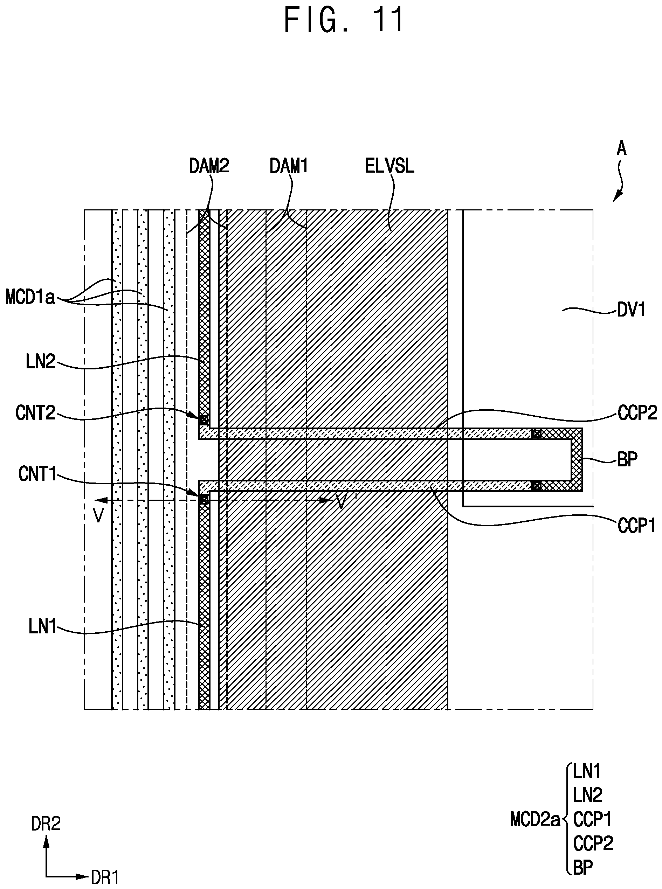

FIG. 11 is an enlarged plan view of an alternative embodiment corresponding to area A of FIG. 1.

Hereinafter, any repetitive detailed descriptions of the same or like elements as those of the display device DD described above with reference to FIGS. 1 and 5 will be omitted or simplified.

FIGS. 1 and 11, an embodiment of the display device DD may include the first crack detection portion M1, the second crack detection portion M2, the common voltage line ELVSL, the first dam DAM1, the second dam DAM2, and the first driver DV1 disposed in the non-display area NDA on the substrate SUB.

A part of the first crack detection line MCD1a may extend along the second direction DR2. In an embodiment, at least a part of the first crack detection line MCD1a adjacent to an end of the first driver DV1 may extend parallel to an edge of the substrate SUB. That is, at least a part of the first crack detection line MCD1a adjacent to the end of the first driver DV1 may not be bent.

The second crack detection line MCD2a may include the first line part LN1, the second line part LN2, the first connection part CCP1, the second connection part CCP2, and the bridge pattern BP. The first line part LN1 may contact the first connection part CCP1 through the first contact hole CNT1, and the second line part LN2 may contact the second connection part CCP2 through the second contact hole CNT2. In addition, the first and second connection parts CC1 and CCP2 may be connected to each other through the bridge pattern BP. In an embodiment, each of the first and second connection parts CCP1 and CCP2 may contact the bridge pattern BP through a contact hole in the first driver DV1.

In an embodiment, the first and second contact holes CTN1 and CNT2 may overlap the second dam DAM1 in the plan view. That is, the first and second contact holes CTN1 and CNT2 may not overlap the first dam DAM1 or may not be positioned between the first dam DAM1 and the second dam DAM2 in the plan view.

In an embodiment, each of the first and second line parts LN1 and LN2 does not overlap the first dam DAM1 and may overlap the second dam DAM2 in the plan view. That is, a part of each of the first and second line parts LN1 and LN2 adjacent to the end of the first driver DV1 may extend parallel to the edge of the substrate SUB.

In an embodiment, the common voltage line ELVSL may overlap the first dam DAM1 and partially overlap the second dam DAM2 in the plan view. That is, the first dam DAM1 may entirely overlap the common voltage line ELVSL.

Each of the first and second connection parts CCP1 and CCP2 may be spaced apart from the first crack detection line MCD1a by a predetermined distance in the plan view.

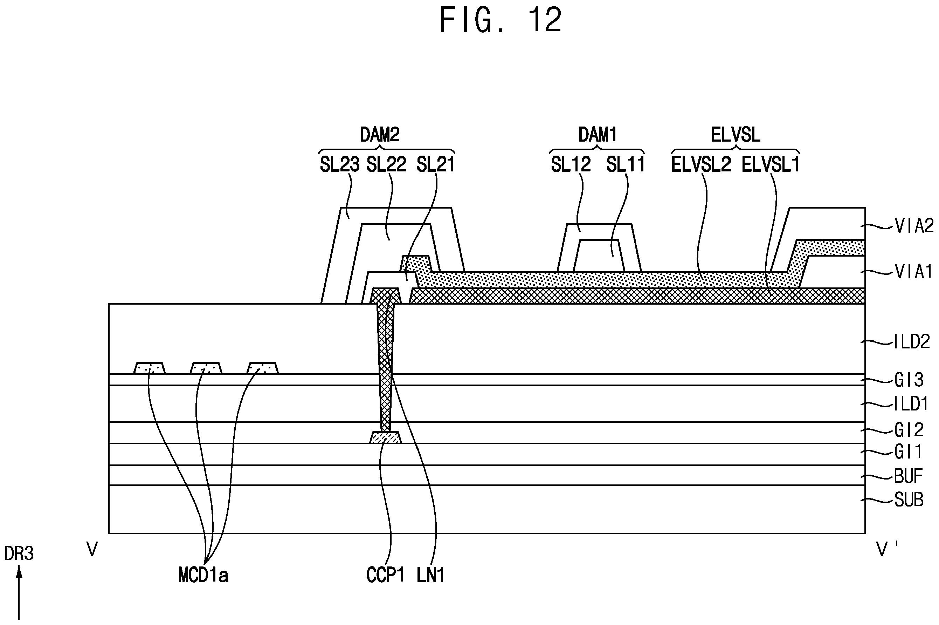

FIG. 12 is a cross-sectional view taken along line V-V' of FIG. 11.

Hereinafter, any repetitive detailed descriptions of the same or like elements as those of the display device DD described above with reference to FIGS. 1, 4, 6, 7, 8, 9, and 10 will be omitted or simplified.

Referring to FIG. 12, in an embodiment where the first crack detection line MCD1a is provided in plural, the first crack detection lines MCD1a may be disposed in a same layer as each other. In an embodiment, the first crack detection line MCD1a may be disposed in a same layer as a third gate electrode (e.g., the third gate electrode GE3 of FIG. 3). That is, the first crack detection line MCD1a may be formed using a same material as the third gate electrode through a same process on the third gate insulating layer GI3. In such an embodiment, the first and second connection parts CCP1 and CCP2 may be disposed in a same layer as a first gate electrode (e.g., the first gate electrode GE1 of FIG. 4).

Accordingly, as the first crack detection line MCD1a and the first connection part CCP1 (or the second connection part CCP2) are spaced apart by a predetermined distance in the third direction DR3, defects due to electrostatic discharge generated in the first and second connection parts CCP1 an CCP2 can be effectively prevented. Here, the third direction DR3 may be a thickness direction.

Referring back to FIGS. 1 and 5 to 10, the display device DD according to an embodiment of the present disclosure may include the plurality of first crack detection lines MCD1a disposed in the non-display area NDA, at least a part of each of the first crack detection lines MCD1a adjacent to the end of the driver DV1 extending in parallel with an edge of the substrate SUB, the second crack detection line MCD2a disposed in the non-display area NDA, electrically connected to the first crack detection lines MCD1a, and positioned between the first crack detection lines MCD1a and the driver DV1, and the common voltage line ELVSL disposed in the non-display area NDA, that provides a common voltage to the pixels PX. The concave portion CP overlapping at least a part of the second crack detection line MCD2a in a plan view may be defined at the edge of the common voltage line ELVSL facing the first crack detection lines MCD1a. Accordingly, defects due to electrostatic discharge generated in a crack detection line can be effectively prevented. In such an embodiment, the dead space of the display device DD can be reduced.

Referring back to FIGS. 1, 11, and 12, the display device according to an alternative embodiment of the present disclosure may include the plurality of first crack detection lines MCD1a disposed in a non-display area NDA, at least a part of each of the first crack detection lines MCD1a adjacent to the end of the driver DV1 extending in parallel with an edge of the substrate SUB, and the second crack detection line MCD2a disposed in the non-display area NDA, electrically connected to the first crack detection lines MCD1a, and positioned between the first crack detection lines MCD1a and the driver DV1. In such an embodiment, each of the first crack detection lines MCD1a may be disposed in the same layer as the third gate electrode (e.g., the third gate electrode GE3 of FIG. 4), and the first and second connection parts CCP1 and CCP2 of the second crack detection line MCD2a may be disposed in a same layer as the first gate electrode (e.g., the first gate electrode GE1 of FIG. 4). Accordingly, defects due to electrostatic discharge generated in a crack detection line can be effectively prevented. In such an embodiment, the dead space of the display device DD can be reduced.

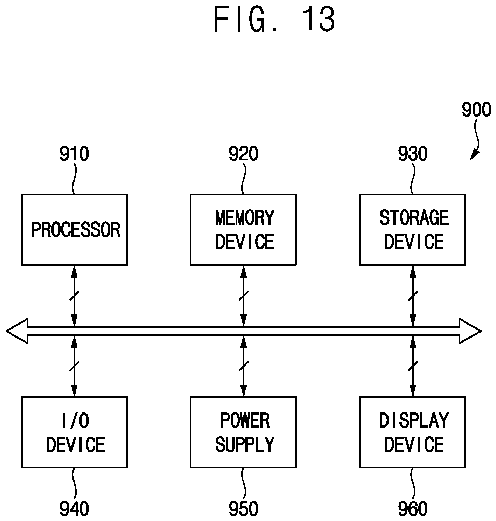

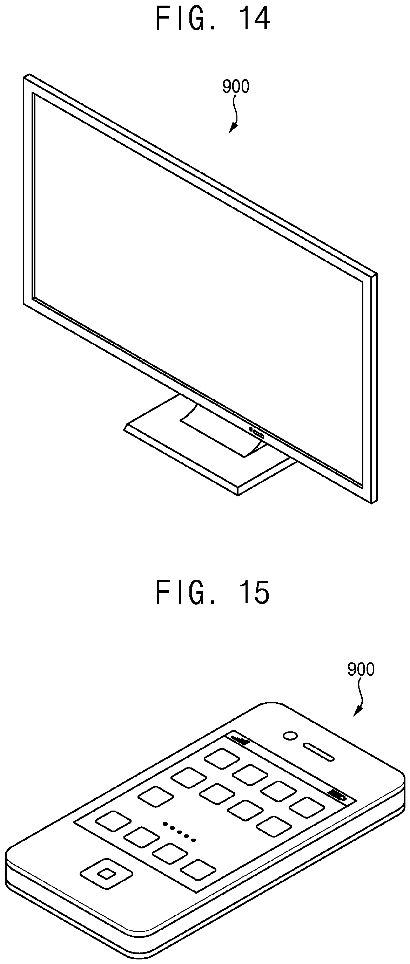

FIG. 13 is a block diagram illustrating an embodiment of an electronic device including the display device of FIG. 1. FIG. 14 is a view illustrating an embodiment in which the electronic device of FIG. 13 is implemented as a television. FIG. 15 is a view illustrating an embodiment in which the electronic device of FIG. 13 is implemented as a smart phone.

Referring to FIGS. 13, 14, and 15, in an embodiment, an electronic device 900 may include a processor 910, a memory device 920, a storage device 930, an input/output (I/O) device 940, a power supply 950, and a display device 960. In such an embodiment, the display device 960 may correspond to the display device DD described with reference to FIGS. 1 to 12. The electronic device 900 may further include several ports capable of communicating with a video card, a sound card, a memory card, a USB device, and the like.

In an embodiment, as shown in FIG. 14, the electronic device 900 may be implemented as a television. In an alternative embodiment, as shown in FIG. 15, the electronic device 900 may be implemented as a smart phone. However, the electronic device 900 is not limited thereto, and alternatively, for example, the electronic device 900 may be implemented as a mobile phone, a video phone, a smart pad, a smart watch, a tablet personal computer (PC), a vehicle navigation device, a computer monitor, a laptop computer, a head mounted display (HMD), or the like.

The processor 910 may perform certain calculations or tasks. In an embodiment, the processor 910 may be a microprocessor, a central processing unit (CPU), an application processor (AP), and/or the like. The processor 910 may be connected to other components through an address bus, a control bus, a data bus, and the like. The processor 910 may also be connected to an expansion bus, such as a peripheral component interconnect (PCI) bus.

The memory device 920 may store data used for the operation of the electronic device 900. In an embodiment, for example, the memory device 920 may include an erasable programmable read-only memory (EPROM) device, an electrically erasable programmable read-only memory (EEPROM) device, a flash memory device, a phase change random access memory (PRAM) device, a resistance random access memory (RRAM) device, a nano-floating gate memory (NFGM) device, a polymer random access memory (PoRAM) device, a magnetic random access memory (MRAM) device, a non-volatile memory device such as a ferroelectric random access memory (FRAM) device and/or a volatile memory device such as a dynamic random access memory (DRAM) device, a static random access memory (SRAM) device, and a mobile DRAM device, or the like.

The storage device 930 may include a solid state drive (SSD), a hard disk drive (HDD), a CD-ROM, or the like.

The I/O device 940 may include input means such as a keyboard, keypad, touch pad, touch screen, mouse, or the like, and output means such as a speaker, a printer, or the like.

The power supply 950 may supply power necessary for the operation of the electronic device 900. The display device 960 may be connected to other components through buses or other communication links. In an embodiment, the display device 960 may be included in the I/O device 940.

The present disclosure can be applied to various display devices, such as display devices for vehicles, ships and aircraft, portable communication devices, display devices for exhibition or information transmission or medical display devices, for example.

The invention should not be construed as being limited to the embodiments set forth herein. Rather, these embodiments are provided so that this disclosure will be thorough and complete and will fully convey the concept of the invention to those skilled in the art.

## Claims

1. A display device (DD) comprising:
a substrate (SUB) including a display area (DA), in which a plurality of pixels (PX) are disposed, and a non-display area (NDA) defined around the display area (DA);
a driver (DV1, DV2) disposed in the non-display area (NDA) on the substrate (SUB);
a plurality of first crack detection lines (MCD1) disposed in the non-display area (NDA) on the substrate (SUB), wherein at least a part of each of the first crack detection lines (MCD1a, MCD1b) adjacent to an end of the driver (DV1, DV2) extends in parallel with an edge of the substrate (SUB) in a plan view;
a second crack detection line (MCD2a, MCD2b) disposed in the non-display area (NDA) on the substrate (SUB) and positioned between the first crack detection lines (MCD1a, MCD1b) and the driver (DV1, DV2), wherein the second crack detection line (MCD2a, MCD2b) is electrically connected to the first crack detection lines (MCD1a, MCD1b); and
a common voltage line (ELVSL) disposed in the non-display area (NDA) on the substrate (SUB), wherein the common voltages line (ELVSL) provides a common voltage (ELVSS) to the pixels (PX), and a concave portion (CP) overlapping at least a part of the second crack detection line (MCD2a, MCD2b) in the plan view is defined at an edge portion of the common voltage line (ELVSL) facing the first crack detection lines (MCD1a, MCD1b).

2. The display device (DD) of claim 1, further comprising:
a first dam (DAM1) disposed in the non-display area (NDA) on the substrate (SUB), and positioned between the first crack detection lines (MCD1a, MCD1b) and the driver (DV1, DV2); and
a second dam (DAM2) disposed in the non-display area (NDA) on the substrate (SUB), and positioned between the first dam (DAM1) and the first crack detection lines (MCD1a, MCD1b).

3. The display device (DD) of claim 1 or 2, wherein
the common voltage line (ELVSL) partially overlaps each of the first and second dams (DAM1, DAM2) in the plan view, and
the concave portion (CP) partially overlaps each of the first and second dams (DAM1, DAM2) in the plan view.

4. The display device (DD) of any of claims 1 to 3, wherein the second crack detection line (MCD2a, MCD2b) includes:
a first line part (LN1);
a first connection part (CCP1) connected to the first line part (LN1);
a second line part (LN2) spaced apart from the first line part (LN1); and
a second connection part (CCP2) connected to the second line part (LN2), and
wherein the first connection part (CCP1) contacts the first line part (LN1) through a first contact hole (CNT1), and the second connection part (CCP2) contacts the second line part (LN2) through a second contact hole (CNT2).

5. The display device of claim 4, wherein the first and second contact holes (CNT1, CTN2) overlap the first dam (DAM1) in the plan view.

6. The display device of claim 4, wherein each of the first and second line parts (LN1, LN2) partially overlaps each of the first and second dams (DAM1, DAM2) in the plan view.

7. The display device (DD) of claim 4, wherein parts of the first and second line parts (LN1, LN2) which do not overlap with the first and second dams (DAM1, DAM2) are not covered with an organic layer.

8. The display device (DD) of claim 4, wherein at least a part of each of the first and second line parts (LN1, LN2) does not overlap the first and second dams (DAM1, DAM2).

9. The display device (DD) of any of claims 4 to 8, wherein
the second crack detection line (MCD2a, MCD2b) further includes a bridge pattern (BP) connected between the first and second connection parts (CCP1, CCP2), and
each of the first and second connection parts (CCP1, CCP2) contacts the bridge pattern (BP) through a contact hole defined in the driver (DV1, DV2).

10. The display device (DD) of any of claims 1 to 9, further comprising:
a first active pattern (ACT1) disposed in the display area (DA) on the substrate (SUB);
a first gate electrode (GE1) disposed on the first active pattern (ACT1);
a second gate electrode (GE2) disposed on the first gate electrode (GE1);
a second active pattern (ACT2) disposed on the second gate electrode (GE2);
a third gate electrode (GE3) disposed on the second active pattern (ACT2);
a source electrode (SE1, SE2) and a drain electrode (DE1, DE2) disposed on the third gate electrode (GE3); and
a connection electrode (CE) disposed on the drain electrode (DE1, DE2).

11. The display device (DD) of any of claims 4 to 10, wherein
each of the first and second line parts (LN1, LN2) is disposed in a same layer as the source electrode (SE1, SE2) and the drain electrode (DE1, DE2),
each of the first and second connection parts (LN1, LN2) is disposed in a same layer as the first gate electrode (GE1), and
each of the first crack detection lines (MCD1a, MCD1b) is disposed in a same layer as the second gate electrode (GE2).

12. The display device (DD) of claim 10, wherein the first crack detection lines (MCD1a, MCD1b) includes:
a first first crack detection line (MCD1a_1) disposed in a same layer as the first gate electrode (GE1);
a second first crack detection line (MCD1a_2) disposed in a same layer as the second gate electrode (GE2); and
a third first crack detection line (MCD1a_3) disposed in a same layer as the third gate electrode (GE3).

13. The display device of claim 12, wherein the first first crack detection line (MCD1a_1), the second first crack detection line (MCD1a_2), and the third first crack detection line (MCD1a_3) overlap each other in the plan view.

14. The display device (DD) of any of claims 10 to 13, wherein the common voltage line (ELVSL) includes:
a first layer (ELVSL1) disposed in a same layer as the source electrode (SE1, SE2) and the drain electrode (DE1, DE2); and
a second layer (ELVSL2) disposed in a same layer as the connection electrode (CE).

15. The display device of claim 1, wherein the first crack detection lines (MCD1a, MCD1b) are disposed in a same layer as each other.

16. A display device (DD) comprising:
a substrate (SUB) including a display area (DA), in which a plurality of pixels (PX) are disposed, and a non-display area (NDA) defined around the display area (DA);
a driver (DV1, DV2) disposed in the non-display area (NDA) on the substrate (SUB);
a plurality of first crack detection lines (MCD1) disposed in the non-display area (NDA) on the substrate (SUB), wherein at least a part of each of the first crack detection lines (MCD1a, MCD1b) adjacent to an end of the driver (DV1, DV2) extends in parallel with an edge of the substrate (SUB) in a plan view; and
a second crack detection line (MCD2a, MCD2b) disposed in the non-display area (NDA) on the substrate (SUB), and positioned between the first crack detection lines (MCD1a, MCD1b) and the driver (DV1, DV2), wherein the second crack detection line (MCD2a, MCD2b) is electrically connected to the first crack detection lines (MCD1a, MCD1b).

17. The display device of claim 16, further comprising:
a first dam (DAM1) disposed in the non-display area (NDA) on the substrate (SUB), and positioned between the first crack detection lines (MCD1a, MCD1b) and the driver (DV1, DV2); and
a second dam (DAM2) disposed in the non-display area (NDA) on the substrate (SUB), and positioned between the first dam (DAM1) and the first crack detection lines (MCD1a, MCD1b).

18. The display device of claim 17, wherein the second crack detection line includes:
a first line part (LN1);
a first connection part (CCP1) connected to the first line part (LN1);
a second line part (LN2) spaced apart from the first line part (LN1); and
a second connection part (CCP2) connected to the second line part (LN2), and
wherein the first connection part (CCP1) contacts the first line part (LN1) through a first contact hole (CNT1) and the second connection part (CCP2) contacts the second line part (LN2) through a second contact hole (CNT2).

19. The display device of claim 18, wherein
the second crack detection line (MCD2a, MCD2b) further includes a bridge pattern (BP) connected between the first and second connection parts (CCP1, CCP2), and
each of the first and second connection parts (CCP1, CCP2) contacts the bridge pattern(BP) through a contact hole in the driver (DV1, DV2).

20. The display device (DD) of claim 18, further comprising:
a first active pattern (ACT1) disposed in the display area (DA) on the substrate (SUB);
a first gate electrode (GE1) disposed on the first active pattern (ACT1);
a second gate electrode (GE2) disposed on the first gate electrode (GE1);
a second active pattern (ACT2) disposed on the second gate electrode (GE2); and
a third gate electrode (GE3) disposed on the second active pattern (ACT2);
wherein the first crack detection lines (MCD1a, MCD1b) are disposed in a same layer as the third gate electrode (GE3), and each of the first and second connection parts (LN1, LN2) is disposed in a same layer as the first gate electrode (GE1).

21. The display device of any of claims 18 to 20, further comprising:
a common voltage line (ELVSL) disposed in the non-display area (NDA) on the substrate (SUB), wherein the common voltage line (ELVSL) provides a common voltage to the pixels (PX),
wherein the common voltage line (ELVSL) overlaps the first dam (DAM1) and partially overlaps the second dam (DAM2) in the plan view.

22. The display device of any of claims 18 to 21, wherein the first and second contact holes (CNT1, CNT2) overlap the second dam (DAM2) in the plan view.

23. The display device of any of claims 18 to 22, wherein each of the first and second line parts (LN1, LN2) does not overlap the first dam (DAM1) and overlaps the second dam (DAM2) in the plan view.
